(19) Europäisches Patentamt
European Patent Office
Office européen des brevets

(11) EP 4 722 743 A1

(12) EUROPEAN PATENT APPLICATION

(43) Date of publication:
08.04.2026 Bulletin 2026/15

(21) Application number: 24203899.0

(22) Date of filing: 01.10.2024

(51) International Patent Classification (IPC):
G01R 31/08 (2020.01)

(52) Cooperative Patent Classification (CPC):
G01R 31/085; G01R 27/16

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: Hitachi Energy Ltd
8050 Zürich (CH)

(72) Inventors:
• GEORGE, Neethu
560049 Bangalore (IN)
• NAIDU, Obbalareddi Demudu
560087 Bangalore (IN)

(74) Representative: Vossius & Partner
Patentanwälte Rechtsanwälte mbB
Siebertstrasse 3
81675 München (DE)

(54) METHODS, DEVICE AND STORAGE MEDIUM FOR DETERMINING A FAULT SECTION AND FAULT LOCATION ON SERIES-COMPENSATED TRANSMISSION LINES

(57) The present disclosure relates to a method for determining a fault section in a series-compensated transmission line, the method comprising: obtaining impedance parameters of the transmission line; obtaining a first voltage and a first current at a first bus; obtaining a second voltage and a second current at a second bus; obtaining a current through an series compensator in a direction towards the first bus, wherein the series compensator is arranged between the first bus and the second bus; and determining a fault section based on: the impedance parameters, the first voltage and the first current, the second voltage and the second current, and the current through the series compensator.

Fig. 1

**Description**

The present disclosure relates to methods for determining a fault section and methods for fault location on series-compensated transmission lines. The disclosure also relates to a corresponding computer-readable storage medium, apparatus, and power grid.

In particular, the disclosure relates to a closed form solution for determining a fault section and a closed-form solution for fault location on series-compensated transmission lines.

Power supply following a fault on a transmission line can be restored only after a damage caused by the fault is repaired. For this purpose, it is important that the location of a fault is accurately known, as otherwise, the whole transmission line needs to be inspected. The process of identifying the exact position of a fault on a transmission is commonly known as fault location (FL). Considering that such transmission lines usually spread over hundreds of kilometers, suboptimal determination of a fault location can lead to significant delay in restoring power supply. Accurate fault location on a transmission line is therefore a crucial task for both IED manufacturers and utility maintenance staff.

On series compensated (SC) transmission lines, series compensation is provided by a series compensator that comprises a capacitor. The series compensator further requires a protective circuit in case of failure when, e.g., the voltage on the capacitor exceed its normal value, leading to damage to the capacitor. Typically, metal oxide varistors (MOVs) and air gaps are used as protective circuits. The state of the art provides several known FL methods on series compensated lines. However, common and challenging issues are (1) nonlinear behaviors of MOVs during a fault affecting accuracy of fault location in such lines, particularly for impedance or phasor-based fault location techniques, and (2) the lack of knowledge of the SC model during the fault.

FL methods in [1,2] and other similar works require either knowledge of the SC model or use assumptions and approximations for the SC model for fault location. However, knowing the SC model is impractical, and the employed approximations lead to errors in fault location. FL methods discussed in [3] use complex optimization and fuzzy logic techniques, while FL methods discussed in [4,5] use iterative calculations, the Newton-Raphson method being the most used, or search algorithms to solve a non-linear problem for fault location. However, these methods require substantial computational resources. Many known FL methods also require different subroutines to be run, followed by selection of a correct solution from multiple possible solutions for fault location. Additionally, many FL methods such as, e.g., methods discussed in [2,4], require the fault type to be known.

There is therefore a need for an improved FL method that allows accurate fault location with minimal dependence on knowledge of the actual SC model.

Some or all of the drawbacks of the prior art are addressed by the disclosure as defined by the independent claims. Preferred embodiments are defined by the sub-features of the dependent claims.

The present disclosure relates to a method for determining a fault section in a series-compensated transmission line, the method comprising obtaining impedance parameters of the transmission line, obtaining a first voltage and a first current at a first bus, obtaining a second voltage and a second current at a second bus, and obtaining a current through an series compensator in a direction towards the first bus, wherein the series compensator is arranged between the first bus and the second bus. The method further comprises determining a fault section based on the impedance parameters, the first voltage and the first current, the second voltage and the second current, and the current through the series compensator.

This provides a non-iterative method for determining a fault section that requires neither nonlinear solving methods, nor identification of the fault type or information regarding the series compensator. Notably, since the series compensator is a series electric circuit element, current entering the series compensator on one side the current leaving the series compensator on the opposite side are substantially equal to each other. Consequently, all necessary values for determining a fault section can be obtained from voltage and current signals at buses either side of the series compensator and from the current through the series compensator.

It is to be noted that, in the context of the present disclosure, obtaining a value or signal can mean measuring the value or signal using a suitable sensor or device, calculating the value or signal based on available data, and/or receiving the value or signal via any suitable information transmission means.

Various embodiments may preferably implement the following features.

Preferably, determining a fault section comprises determining whether the fault is located between a first section of the transmission line from the first bus to the series compensator, or a second section of the transmission line from the second bus to the series compensator.

This facilitates further fault location by restricting the location of the fault to either a section before or after the series compensator and eliminates the need for running one or more subroutines for different sections on the transmission line that are necessary in FL methods of the prior art.

Preferably, determining a fault section comprises obtaining a first reactive power at the series compensator on a side towards the first bus and obtaining a second reactive power at the second bus.

This provides a non-iterative and further simplified method for determining a fault section that does not require any knowledge of the SC model.

Preferably, in the preceding aspect, determining a fault section comprises determining a sign change between the first reactive power and the second reactive power.

This provides a computationally efficient and effective manner of determining a fault section.

The present disclosure also relates to a method for fault location in a series-compensated transmission line, the method comprising obtaining impedance parameters of the transmission line, obtaining a first voltage and a first current at a first bus, obtaining a second voltage and a second current at a second bus, and obtaining a current through an series compensator in a direction towards the first bus, wherein the series compensator is arranged between the first bus and the second bus. The method further comprises determining a fault location based on the impedance parameters, the first voltage and the first current, the second voltage and the second current, and the current through the series compensator.

This provides a non-iterative method for determining a fault section that requires neither nonlinear solving methods, nor identification of the fault type or information regarding the series compensator. Notably, since the series compensator is a series electric circuit element, current entering the series compensator on one side the current leaving the series compensator on the opposite side are substantially equal to each other. Consequently, all necessary values for determining a fault section can be obtained from voltage and current signals at buses either side of the series compensator and from the current through the series compensator.

Various embodiments may preferably implement the following features.

Preferably, the fault location is determined based on the reactive power flowing through the fault being zero.

Accordingly, since fault resistance is exclusively of resistive nature, power flowing through the fault resistance is exclusively active power. Consequently, reactive power flowing through the fault resistance is zero. This allows fault location to be independent of the fault type.

The present disclosure also relates to a method for determining a fault location in a series-compensated transmission line, the method comprising performing a method for determining a fault section in a series-compensated transmission line as described above, and subsequently performing a method for fault location in a series-compensated transmission line as described above.

In addition to the aforementioned advantages, by performing the method for determining a fault section, the subsequently performed method for fault location can be restricted to the determined fault section, thus eliminating the need for running one or more subroutines for each section on the transmission line. Additionally, the method for subsequent fault location requires the same inputs, measurements, and largely the same process steps as the preceding method for determining a fault section, thus minimizing the number of required inputs, measurements, and process steps. The combination of the method for determining a fault section in a series-compensated transmission line as described above and the method forfault location in a series-compensated transmission line as described above combines synergistically to provide accurate fault location with substantially reduced computational requirements.

Various embodiments may preferably implement the following features.

Preferably, determining the fault location is performed on the first section of the transmission line when the fault is determined to be located in the first section, or determining the fault location is performed on the second section of the transmission line when the fault is determined to be located in the second section.

This allows subsequent fault location to be restricted to a well-defined section either after or before the series compensator between two buses of a transmission line, providing a simplified method for fault location with further reduced computational requirements.

Preferably, the current through the series compensator is determined based on either the second voltage and the second current, or the first voltage and the first current.

This eliminates the need for a dedicated sensor or device for detecting a current flowing through the series compensator, thus further simplifying the method for fault location.

Preferably, the reactive power is determined based on a linear approximation of the reactive power.

As employing a linear approximation this simplifies determining a fault location and further reduces computational requirements.

Preferably, one or more boundary condition values of the linear approximation are determined without applying the linear approximation of the reactive power.

As determining boundary values for the linear approximation this improves the fault location accuracy without introducing nonlinear problems or iterative steps that would otherwise lead to an increase in computational requirements.

Preferably, the impedance parameters of the transmission line comprise one or more of ABCD parameters of the transmission line, a fault type, and length of the transmission line.

As these parameters can readily be determined and do not require any knowledge of the SC model this contributes to a simplified and more accurate method for fault location.

The present disclosure also relates to an apparatus of a power network, the apparatus comprising one or more processors configured to perform the method as described above.

The present disclosure also relates to a computer program product comprising instructions that, when executed by one or more processors of a management system of a power network, cause the one or more processors to perform the method as described above.

The present disclosure also relates to a non-transitory computer-readable storage medium comprising the computer program product as described above.

## Brief description of the drawings

Fig. 1 shows a schematic illustration of an equivalent circuit of a portion of a series compensated transmission line with a fault, according to embodiments of the present disclosure.

Fig. 2 shows a flow chart illustrating a method for fault location according to embodiments of the present disclosure.

Fig. 3A and 3B respective show a diagram illustrating fault reactive power over fractional location of fault for fault location according to embodiments of the present disclosure.

Fig. 4 shows a flow chart illustrating a method for determining a fault section according to embodiments of the present disclosure.

Fig. 5 shows a flow chart illustrating a method for fault location according to further embodiments of the present disclosure.

## Detailed description

Embodiments of the present disclosure will now be described by way of example only and with reference to the following accompanying drawings. In the figures, the same reference numerals denote the same or similar elements.

In the following description, although numerous features may be designated as optional, it is nevertheless acknowledged that all features comprised in the independent claims are not to be read as optional.

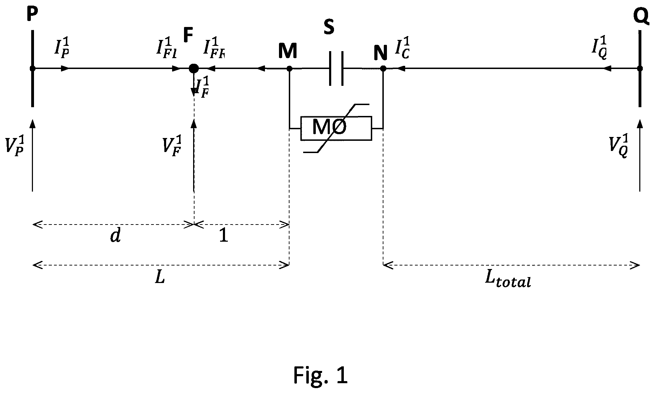

**Fig. 1** illustrates an exemplary equivalent circuit for a series compensated transmission line on which a fault at point F1 has occurred. Merely as an example is the equivalent circuit shown as a positive sequence equivalent circuit diagram. It is to be noted that that methods of the present disclosure for fault location and determination of a fault section are independent of the type of fault, i.e., independent of whether the fault is a, e.g., A-G or B-C type fault.

In the illustrated equivalent circuit, the series compensator is arranged between a first bus P and a second bus Q. The series compensator is shown to comprise a capacitor, and an MOV as a protective circuit, although the series compensator can generally have any suitable configuration.

A node at the series compensator on the side towards the first bus P is denoted as node M, and a node at the series compensator on the side towards the second bus Q is denoted as node N. As can be seen, the transmission line can generally be divided into two sections, a first section PM located before the series compensator and spanning from the first bus P to node M, and a second section NQ located after the series compensator and spanning from node N to the second bus Q. The sum of the length $L$ of section PM and the length $L_{total} - L$ of section NQ is equal to the total length $L_{total}$ of the transmission line spanning between the first bus P and the second bus Q.

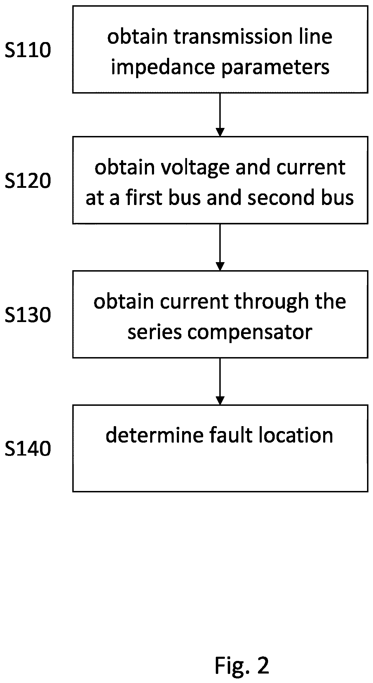

**Fig. 2** illustrates a method for fault location according to a preferred embodiment of the present disclosure.

In a first step S110, impedance parameters of the transmission line are obtained. Example of impedance parameters include, but are not limited to, a total length $L_{total}$ of the transmission line spanning from the first bus P to the second bus Q, and parameters characterizing a transmission line as a two-port network such as, for example, Z-parameters or, preferably, ABCD parameters.

In a second step S120, a first voltage signal $V_p$ and first current signal $I_P$ at the first bus P, and a second voltage signal $V_Q$ and a second current signal $I_Q$ at the second bus Q are obtained, preferably by performing a respective measurement at the first bus P and at the second bus Q using suitable sensors or devices. Notably, $V_p$ and $I_P$ are preferably the locally measured three phase voltage and current quantities at bus P. Similarly, $V_Q$ and $I_Q$ are preferably the locally measured three phase voltage and current quantities at bus Q.

In a third step S130, a current $I_C$ flowing through the series compensator as a series circuit element corresponding to the current flowing from section NQ into section PM is obtained. It should be noted that, in a case where the fault point F1 is located in section NQ, the current $I_C$ corresponds to the current flowing in the opposite direction from section PM through the series compensator into section NQ. The current $I_C$ can be obtained via suitable measurements at either node M or N at the series compensator if a suitable sensor or device is arranged on the transmission line. However, it is preferable to determine the current $I_C$ based on the obtained second voltage $V_Q$ and second current signal $I_Q$. In case of a fault in section NQ, the current $I_C$ can be determined based on the obtained the first voltage signal $V_p$ and first current signal $I_P$.

In a fourth step 140, based on the obtained impedance parameters obtained in step 110, the first voltage signal $V_p$ and first current signal $I_P$, the second voltage signal $V_Q$ and second current signal $I_Q$ obtained in step 120, and the current $I_C$ obtained in step 130, the fault location $d$ can be determined. Notably, fault location can preferably be determined based on the fact that the reactive power flowing into the fault path is zero owing to the purely ohmic fault impedance.

Once the parameters and signals in steps 110 and 120 are obtained, in a preferred embodiment, steps 130 and 140 can be performed as detailed below.

For a fault F1 located on section PM of line PQ between bus P and the series compensator SC, as illustrated in Fig.1, $V_p$ and $I_P$ are the locally measured three phase voltage and current at bus

P and $V_Q$ and $I_Q$ are three phase voltage and current quantities at bus Q. Line impedance are expressed using the distributed long line model for transmission lines through ABCD parameters. The total line length is $L_{total}$ km. The series compensator is at arranged a distance of $L$ km from terminal P. The fault point F1 is located at a to be determined fractional location d from bus P, expressed as fraction of section PM.

The total power flowing into the fault path is given as

$$S_F = V_F I_F^*$$
(1)

where $V_F$, $I_F$ are the fault point voltage and the fault current flowing into the fault path at fault point F1, respectively.

For any type of fault, the fault point voltage and fault current can be given as

$$V_F = V_F^1 + V_F^2 + V_F^0$$
(2)

$$I_F = I_F^1 + I_F^2 + I_F^0$$
(3)

where superscripts *1, 2, 0* respectively denote positive, negative and zero sequence components of the respective quantities

In terms of available measurements and ABCD parameters of the line, $V_F$ and $I_F$ can be given as follows.

For the positive sequence equivalent circuit diagram for fault F1 as illustrated in Fig.1, the positive sequence fault point voltage is

$$V_F^1 = A_d^1 V_P^1 + B_d^1 I_P^1$$
(4)

wherein $V_P^1$, $I_P^1$ are positive components of the first voltage $V_P$ and the first current $I_P$ at bus P, wherein

$$A_d^1 = -D_d^1 = \cosh\left(\gamma^1 dL\right), B_d^1 = -Z_c^1 \sinh\left(\gamma^1 dL\right), C_d^1 = \frac{1}{Z_c^1} \sinh\left(\gamma^1 dL\right),$$

and

$$Z_c^1 = \sqrt{\frac{r^1 + j\omega l^1}{j\omega c^1}}, \gamma^1 = \sqrt{(r^1 + j\omega l^1)(j\omega c^1)},$$

wherein $r^1$, $l^1$, $c^1$ are positive sequence resistance, inductance, and capacitance, each per unit length of the line, and $L$ is the length of the section PM. Negative and zero sequence fault point voltage can be given by simply replacing the positive sequence quantities in (4) by negative and zero sequence quantities, respectively.

In combination with equation (2), the total fault point voltage is

$$V_F = (A_d^1 V_P^1 + B_d^1 I_P^1) + (A_d^2 V_P^2 + B_d^2 I_P^2) + (A_d^0 V_P^0 + B_d^0 I_P^0)$$
(5)

Since the attenuation constant $\gamma$ typically has a very small value, *cosh* of this quantity can be assumed to be 1, i.e., $A_d^1 = 1$. At the same time, *sinh* of this quantity can be assumed to be the quantity itself.

Consequently, the fault point voltage is

$$V_F = (V_P^1 + B_d^1 I_P^1) + (V_P^2 + B_d^2 I_P^2) + (V_P^0 + B_d^0 I_P^0) \tag{6}$$

Rearranging equation (6) yields:

$$V_F = B_d^1(I_P^1 + I_P^2) + B_d^0(I_P^0) + (V_P^1 + V_P^2 + V_P^0) \tag{7}$$

Substituting with $b_1 = (I_P^1 + I_P^2), b_2 = (I_P^0), b_0 = (V_P^1 + V_P^2 + V_P^0)$, the fault point voltage is

$$V_F = b_1 B_d^1 + b_2 B_d^0 + b_0. \tag{8}$$

Further substituting with $B_d^1 = -Z_c^1 \gamma^1 dL$ and $B_d^0 = -Z_c^0 \gamma^0 dL$ yields

$$V_F = b_0 - d(b_1 Z_c^1 \gamma^1 L + b_2 Z_c^0 \gamma^0 L) \tag{9}$$

Further substituting with $b_3 = (b_1 Z_c^1 \gamma^1 L + b_2 Z_c^0 \gamma^0 L)$, the fault point voltage is

$$V_F = b_0 - db_3 \tag{10}$$

In equation (10) the only unknown is fault location *d*.
Positive sequence fault path current as illustrated in Fig. 1 can be given as

$$I_F^1 = I_{FL}^1 + I_{FR}^1 \tag{11}$$

From two port equivalents of line sections before and after the fault, the fault path current is

$$I_F^1 = -C_d^1 V_P^1 - D_d^1 I_P^1 - \frac{I_C^1 - C_{1-d}^1 V_F^1}{D_{1-d}^1} \tag{12}$$

where

$$D_d^1 = -\cosh(\gamma^1 dL),$$

$$D_d^1 = \frac{1}{Z_c^1} \sinh(\gamma^1 dL),$$

$$D_{1-d}^1 = -\cosh(\gamma^1(1-d)L),$$

and

$$C_{1-d}^1 = \frac{1}{Z_c^1} \sinh(\gamma^1(1-d)L).$$

. $I_C^1$ is the current from the next section NQ after the series compensator through the series compensator into section PM, which can be given as

$$I_C^1 = -C_{L_{total}-L}^1 V_Q^1 - D_{L_{total}-L}^1 I_Q^1 \tag{13}$$

where

$$D^1_{L_{total}-L} = -\cosh\left(\gamma^1(L_{total} - L)\right),$$

$$C^1_{L_{total}-L} = \frac{1}{z^1_c}\sinh\left(\gamma^1(L_{total} - L)\right)$$

and

As stated before, the negative and zero sequence fault path current can be obtained by simply replacing the positive sequence quantities in (12) and (13) with negative and zero sequence quantities, respectively.

Combining the above quantities with equation (3), the total fault current is

$$I_F = \left(-C^1_d V^1_P - D^1_d I^1_P - \frac{I^1_C - D^1_{1-d}V^1_F}{D^1_{1-d}}\right) + \left(-C^2_d V^2_P - D^2_d I^2_P - \frac{I^2_C - D^2_{1-d}V^2_F}{D^2_{1-d}}\right) + \left(-C^0_d V^0_P - D^0_d I^0_P - \right.$$

$$\left. \frac{I^0_C - D^0_{1-d}V^0_F}{D^0_{1-d}}\right) \tag{14}$$

$$I_F = (-C^1_d V^1_P + I^1_P + I^1_C - C^1_{1-d}V^1_F) + (-C^2_d V^2_P + I^2_P + I^2_C - C^2_{1-d}V^2_F) + (-C^0_d V^0_P + I^0_P + I^0_C - $$

$$C^0_{1-d}V^0_F) \tag{15}$$

$$I_F = -C^1_d V^1_P - C^1_{1-d}V^1_F - C^2_d V^2_P - C^2_{1-d}V^2_F - C^0_d V^0_P - C^0_{1-d}V^0_F + a_0 \tag{16}$$

Where $a_0 = (I^1_P + I^1_C + I^2_P + I^2_C + I^0_P + I^0_C)$, and the total fault current is

$$I_F = C^1_d(-V^1_P - V^2_P) + C^1_{1-d}(-V^1_F - V^2_F) + C^0_d(-V^0_P) + C^0_{1-d}(-V^0_F) + a_0$$

Substituting for $V^1_F, V^2_F$ and $V^0_F$ from (4) and similar equations, the total fault current is

$$I_F = a_1 C^1_d - a_2 C^1_{1-d}A^1_d - a_3 C^1_{1-d}B^1_d + a_4 C^0_d - a_5 C^0_{1-d}A^0_d - a_6 C^0_{1-d}B^0_d + a_0$$

where $a_1 = (-V^1_P - V^2_P), a_2 = (V^1_P + V^2_P), a_3 = (I^1_P + I^2_P), a_4 = (-V^0_P), a_5 = (V^0_P)$, and $a_6 = (I^0_P)$.

Substituting simplifications on the hyperbolic functions on A, B and C parameters yields

$$I_F = a_1 \frac{\gamma^1 dL}{z^1_c} - a_2 \frac{\gamma^1(1-d)L}{z^1_c} - a_3(\gamma^1 L)^2 d(1-d) + a_4 \frac{\gamma^0 dL}{z^0_c} - a_5 \frac{\gamma^0(1-d)L}{z^0_c} - a_6(\gamma^0 L)^2 d(1-$$

$$d) + a_0$$

After rearranging and grouping, the total fault current is

$$I_F = d^2 x_2 + d x_1 + x_0 \tag{17}$$

where, $x_2 = (\gamma^1 L)^2 + (\gamma^0 L)^2$, and $x_1 = (a_1 + a_2)\frac{\gamma^1 L}{z^1_c} - a_3(\gamma^1 L)^2 + a_4 \frac{\gamma^0 L}{z^0_c} + a_5 \frac{\gamma^0 L}{z^0_c} + $

$(\gamma^0 L)^2, x_0 = -a_2 \frac{\gamma^1 L}{z^1_c} + a_5 \frac{\gamma^0 L}{z^0_c} + a_0$.

In summary, as indicated by equations (10) and (17), the fault point voltage and the fault current are

$$V_F = b_0 - d b_3 \, ,$$

and

$$I_F = d^2 x_2 + d x_1 + x_0$$

where the only unknown is the fault location *d*.

The fault path power is $S_F = V_F I_F^*$, where * denotes the conjugate.

Substituting from above expressions for $V_F$ and $I_F$, the fault path power is

$$S_F = (b_0 - d b_3)(d^2 x_2 + d x_1 + x_0)^* \tag{18}$$

Since d is the fractional fault location it will always be real. Consequently,

$$S_F = (b_0 - d b_3)(d^2 x_2^* + d x_1^* + x_0^*) \tag{19}$$

By expanding and grouping, the fault path power is determined as

$$S_F = (-b_3 x_2^*)d^3 + (b_0 x_2^* - b_3 x_1^*)d^2 + (b_0 x_1^* - b_3 x_0^*)d + b_0 x_0^*$$

$$S_F = \left(\frac{-b_3 x_2^*}{b_0 x_0^*}\right)d^3 + \left(\frac{b_0 x_2^* - b_3 x_1^*}{b_0 x_0^*}\right)d^2 + \left(\frac{b_0 x_1^* - b_3 x_0^*}{b_0 x_0^*}\right)d + 1$$

Since d being the fractional location is a real number, the imaginary part of $S_F$, i.e. the reactive power $Q_F$ is determined as

$$Q_F = \mathrm{Imag}(S_F) = \mathrm{Imag}\left(\frac{-b_3 x_2^*}{b_0 x_0^*}\right)d^3 + \mathrm{Imag}\left(\frac{(b_0 x_2^* - b_3 x_1^*)}{b_0 x_0^*}\right)d^2 + \mathrm{Imag}\left(\frac{b_0 x_1^* - b_3 x_0^*}{b_0 x_0^*}\right)d + 1 \tag{20}$$

While equation (20) above is of the third order, coefficients of $d^2$ and $d^3$ are of the order $e^{-4}$ and contain the terms $(\gamma^1)^2$ and $(\gamma^0)^2$. Consequently, $d^2$ and $d^3$ are significantly less in comparison to the coefficient of d. Therefore, the coefficient of d is negative.

It can be concluded that the fault path reactive power $Q_F$ has a majorly linear relation of a negative slope with unknown fault location *d*. Additionally, since the fault reactive power $Q_F = 0$ owing to the purely ohmic nature of the fault, the majorly linear relation passes through zero at the actual fault location *d*.

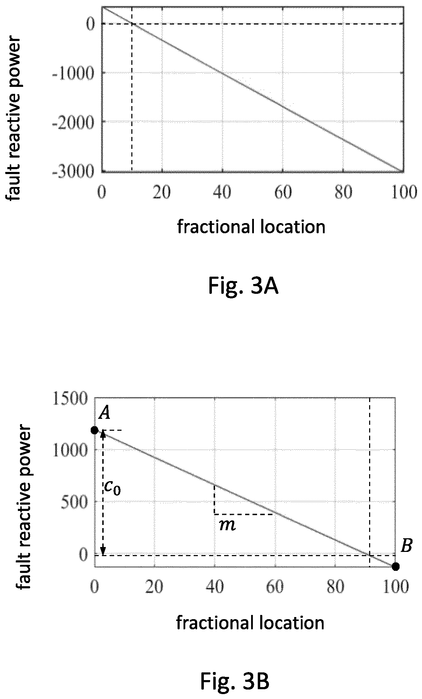

Examples of the majorly linear relation of the fault path reactive power $Q_F$ are illustrated in Figs. **3A** and **3B,** showing fault path reactive power plotted for various values of *d* across the length of section PM, for two different faults. Fig. 3A shows the plot of $Q_F$ vs *d* for an A-G fault located at a distance of 10% of the section with a fault resistance of 10Ω. Fig. 3B shows the plot of $Q_F$ vs *d* for a solid B-C fault located at 90% of the line. As evident, the plots are linear with a negative slope that passes through zero at the actual fault location.

Since the only unknown parameter in equation (20) is the actual fault location *d,* equation (20) is in principle sufficient for determining the actual fault location. However, the inventors found that this approach can, in certain cases, yield suboptimal accuracy, leading to an error in the determined fault location that is higher than desired, i.e., the error is not <1%. This can be attributed to certain assumptions made in the derivation regarding the *sinh* and *cosh* functions. To further improve the accuracy of determining the actual fault location, the following modification based on the above-shown linear nature of $Q_F$ can be performed.

As exemplified in Fig. 3B, the points A and B defining the negative slope m can be obtained by determining the value of $Q_F$ at *d* = 0 and *d* = 1 without placing any assumptions on the cosh and sinh functions. Using the obtained values of *A* and *B,* the parameters of the line *AB* - slope (*m*) and *y* intercept ($c_0$) for the generic line equation $Q_F$ = *md* + $c_0$ - can be determined. From these parameters of line AB, the value of d at which the function $Q_F$ = 0 can be determined for more accurate actual fault location.

As an example, the values of $Q_{F(d=0)}$ and $Q_{F(d=1)}$ can be determined as follows.

Independent of the fault type, $Q_F$ can be given as

$$Q_F = Q_F^1 + Q_F^2 + Q_F^0$$

$$Q_F = \text{Imag}\left(V_F^1 I_F^{1*}\right) + \text{Imag}\left(V_F^2 I_F^{2*}\right) + \text{Imag}\left(V_F^0 I_F^{01*}\right)$$

$$Q_{F(d=0)} = \text{Imag}\left(V_{F(d=0)}^1 I_{F(d=0)}^{1}{}^*\right) + \text{Imag}\left(V_{F(d=0)}^2 I_{F(d=0)}^{2}{}^*\right) + \text{Imag}\left(V_{F(d=0)}^0 I_{F(d=0)}^{01}{}^*\right)$$

$$Q_{F(d=1)} = \text{Imag}\left(V_{F(d=1)}^1 I_{F(d=1)}^{1}{}^*\right) + \text{Imag}\left(V_{F(d=1)}^2 I_{F(d=1)}^{2}{}^*\right) + \text{Imag}\left(V_{F(d=1)}^0 I_{F(d=1)}^{0}{}^*\right)$$

In combination with, e.g., equations (4) and (12), the above can be used to determine the values of $Q_{F(d=0)}$ and $Q_{F(d=1)}$.

It is to be noted that the exemplary equations above are given for a fault point F1 on section PM. The above equations can be modified without requiring a change in input or measurement for a fault on section NQ by substituting the P end quantities with the Q end quantities, and vice versa. If the section of the fault, here either section PM or section NQ is known, the above method for fault location can be performed for that section for accurate fault location.

The present disclosure therefore provides a closed-loop solution for fault location without requiring nonlinear solving methods or iterative methods. It further requires neither the identification of the fault type or any information regarding the SC model. The inventors have found that the above method for fault location can reliably and consistently determining a fault location with less than 1% of the transmission line length.

Prior to performing the fault location methods described above in the context of embodiments illustrated in Figs. 2, 3A, and 3B, it can be advantageous to first determine which in section of the transmission line, i.e., section PM or section NQ, a fault is located. By knowing the faulted section, the section without fault can be ignored when performing the above described fault location methods.

The present disclosure therefore also provides a method for determining a fault section. For a series compensated transmission line as exemplified in Fig. 1, the method for determining a fault section allows determining whether a fault is located in a section before or in a section after the series compensator.

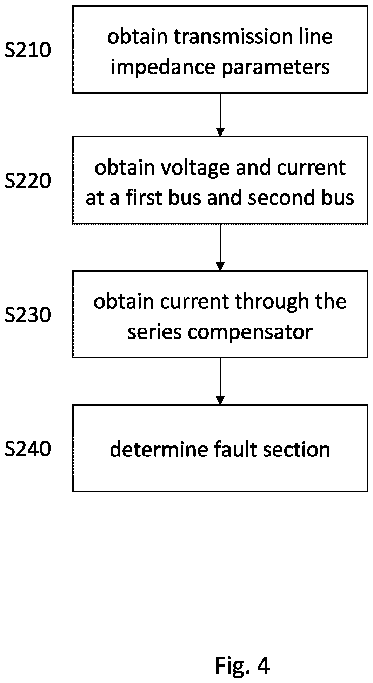

As illustrated in Fig. 4, this method comprises a first step 210 of obtaining transmission line impedance parameters, a second step S220 of obtaining a voltage and current signal at a first bus P and a voltage and current signal at the second bus Q, and a third step S230 of obtaining a current through the series compensator. Here, steps S210, S220, and S230 are respectively substantially identical to steps S110, S120, and S130 described above for embodiments in the context of Figs. 2, 3A, and 3B.

The method for determining a fault section comprises a fourth step S240 in which the fault section is determined. As shown above for methods for fault location for steps S130 and S140 and as illustrated in Figs. 3A and 3B, the plot of $Q_F$ as a function of fault location d on the faulted section, i.e. one of section PM or section NQ, has a zero crossing. In contrast, for the section where the fault is not located, the plot does not have a zero crossing. As a consequence, if the fault is on section PM, the quantity $Q_F^{PM}$ (derived assuming fault on section PM) as a function of fault location will have a zero crossing, and the sign of $Q_{F(d=1)}^{PM}$ will have a negative value. On the other hand, $Q_F^{NQ}$ (derived assuming fault on section NQ) will not have a zero crossing and therefore the sign of $Q_{F(d=1)}^{NQ}$ will have a positive value.

Consequently, the following fault section determination logic can be applied:

$$\text{If } \text{sign}\left(Q_{F(d=1)}^{PM}\right) = -1 \text{ and } \text{sign}\left(Q_{F(d=1)}^{NQ}\right) = 1 \rightarrow \text{fault is on section PM} \tag{21}$$

$$\text{If } \text{sign}\left(Q_{F(d=1)}^{PM}\right) = 1 \text{ and } \text{sign}\left(Q_{F(d=1)}^{NQ}\right) = -1 \rightarrow \text{fault is on section NQ} \tag{22}$$

The present disclosure therefore also provides a closed-loop solution for determining a fault section without requiring nonlinear solving methods or iterative methods. It further requires neither the identification of the fault type or any information regarding the SC model. This eliminates the need for running one or more subroutines per section of the transmission line and allows any suitable method for fault location to be limited to only the determined fault section.

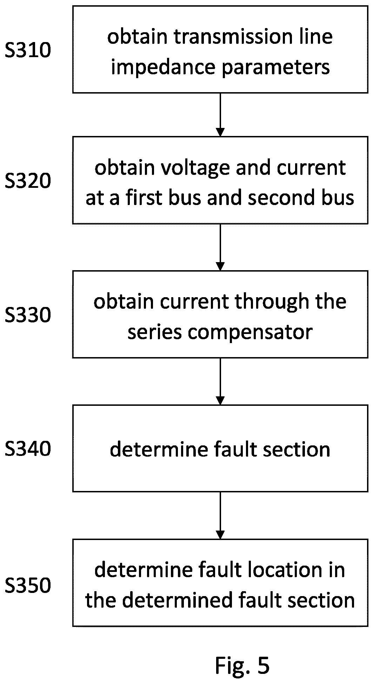

As illustrated by the flowchart shown in Fig. 5, a method for determining a fault section, as described above in the context of embodiments shown in Fig. 4, can be advantageously combined with a method for fault location as described above in the context of embodiments shown in Figs. 2, 3A, and 3B.

The method comprises a first step 310 of obtaining transmission line impedance parameters, a second step S320 of obtaining a voltage and current signal at a first bus P and a voltage and current signal at a second bus Q, and a third step 330 of obtaining a current through the series compensator. Here, steps S310, S320, and S330 are respectively substantially identical to steps S110, S120, and S130 described above for embodiments in the context of Fig. 2, 3A, and 3B, and substantially identical to steps S210, S220, and S230 described for embodiments in the context of Fig. 4.

In a fourth step S340, a fault section is determined, wherein step 340 is substantially identical to step 240 as described above in the context of embodiments shown in Fig. 4.

In a fifth step 350, a fault location is determined as described above for step S140 in the context of embodiments shown in Figs. 2, 3A, and 3B. Here it is to be noted that only one subroutine needs to be performed for the section which was determined as the fault section in step 340. In other words, the process required for step S140 needs only be performed based on the single assumption that the fault point is located in the section - here either section PM or section NQ - that was determined to be the fault section.

This is particularly advantageous, as the combination of methods for determining a fault section according to embodiments of the disclosure with methods for fault location according to embodiments of the disclosure therefore not only eliminates the need for running a subroutine for each section, and requires the same input and measurements and for a large part, the same process steps for both determining the fault section and for fault location within the determined fault section. The combination therefore combines not only the advantages of methods for determining a fault section with the advantages of methods for fault location, according to embodiments disclosure, but further provides the advantage that the requirements of computational resources can be significantly reduced.

The presented accurate methods according to embodiments of the disclosure help users (Electric Utilities), e.g., to fix network faults efficiently and restore power transmission lines quickly, to improve overall network availability and reliability, to reduce repair and restoration cost for utilities and consequently, reduced power bills for end customers, to avoid high-cost patrolling methods like helicopter and drone search and/or to avoid unsafe crew patrolling, especially in difficult geographical terrains thereby Improve safety of the field staff.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any one of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any one of a variety of different technologies and techniques. For example, data, instructions, commands, information, signals, bits, and symbols, for example, which may be referenced in the above description can be represented by voltages, currents, electromagnetic waves, magnetic fields or particles, optical fields or particles, or any combination thereof.

A person of ordinary skill in the art would further appreciate that any one of the various illustrative logical blocks, units, processors, means, circuits, methods and functions described in connection with the aspects disclosed herein can be implemented by electronic hardware (e.g., a digital implementation, an analog implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a person of ordinary skill in the art would understand that various illustrative logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

In this document, the term "unit" as used herein, refers to software, firmware, hardware, and any combination of these elements for performing the associated functions described herein. Additionally, for purpose of discussion, the various units are described as discrete units; however, as would be apparent to one of ordinary skill in the art, two or more units may be combined to form a single unit that performs the associated functions according embodiments of the present disclosure.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organization.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

List of references

[1] G. K. Rao, P. Jena and S. Sarangi, "Adaptive Fault Location Algorithm for Series Compensated Line Using Relay data," 2019 8th International Conference on Power Systems (ICPS), Jaipur, India, 2019, pp. 1-5

[2] M. M. Saha, J. Izykowski, E. Rosolowski and B. Kasztenny, "A new accurate fault locating algorithm for series compensated lines," in IEEE Transactions on Power Delivery, vol. 14, no. 3, pp. 789-797, July 1999

[3] Silvio Giuseppe Di Santo, Alvaro Da Rocha Albertini, Rodrigo Rozenblit Tiferes, "Optimization-Based Fault Location Algorithm for Series-Compensated Power Transmission Lines", IEEE Access, vol.10, pp.46864-46877, 2022.

[4] N. Kang, J. Chen and Y. Liao, "A Fault-Location Algorithm for Series-Compensated Double-Circuit Transmission Lines Using the Distributed Parameter Line Model," in IEEE Transactions on Power Delivery, vol. 30, no. 1, pp. 360-367, Feb. 2015

[5] J. Izykowski, E. Rosolowski, P. Balcerek, M. Fulczyk and M. M. Saha, "Fault Location on Double-Circuit Series-Compensated Lines Using Two-End Unsynchronized Measurements," in IEEE Transactions on Power Delivery, vol. 26, no. 4, pp. 2072-2080, Oct. 2011

**Claims**

1. A method for determining a fault section in a series-compensated transmission line, the method comprising:

obtaining impedance parameters of the transmission line;
obtaining a first voltage and a first current at a first bus;
obtaining a second voltage and a second current at a second bus;
obtaining a current through an series compensator in a direction towards the first bus, wherein the series compensator is arranged between the first bus and the second bus; and
determining a fault section based on:

the impedance parameters,
the first voltage and the first current,
the second voltage and the second current, and
the current through the series compensator.

2. The method according to claim 1, wherein determining a fault section comprises determining whether the fault is located between:

a first section of the transmission line from the first bus to the series compensator, or
a second section of the transmission line from the second bus to the series compensator.

3. The method according to claim 1 or 2, wherein determining a fault section comprises:

obtaining a first reactive power at the series compensator on a side towards the first bus; and
obtaining a second reactive power at the second bus.

4. The method according to claim 3, wherein determining a fault section comprises determining a sign change between the first reactive power and the second reactive power.

5. A method for determining a fault location in a series-compensated transmission line, the method comprising:

obtaining impedance parameters of the transmission line;
obtaining a first voltage and a first current at a first bus;
obtaining a second voltage and a second current at a second bus;
obtaining a current through an series compensator in a direction towards the first bus, wherein the series compensator is arranged between the first bus and the second bus; and
determining a fault location based on:

the impedance parameters,
the first voltage and the first current,
the second voltage and the second current, and
the current through the series compensator.

6. The method according to claim 5, wherein the fault location is determined based on the reactive power flowing through the fault resistance being zero.

7. A method for determining a fault location in a series-compensated transmission line, the method comprising:

performing a method for determining a fault section in a series-compensated transmission line according to any one of claims 1 to 4; and
subsequently performing a method for determining a fault location in a series-compensated transmission line according to any one of claims 5 to 6.

8. The method according to claim 7, wherein:

determining the fault location is performed on the first section of the transmission line when the fault is determined to be located in the first section, or

determining the fault location is performed on the second section of the transmission line when the fault is determined to be located in the second section.

9. The method according to any one of the preceding claims, wherein the current through the series compensator is determined based on either the second voltage and the second current, or the first voltage and the first current.

10. The method according to any one of claims 3, 4, or 6, wherein the reactive power is determined based on a linear approximation of the reactive power.

11. The method according to claim 10, wherein one or more boundary condition values of the linear approximation are determined without applying the linear approximation of the reactive power.

12. The method according to any one of the preceding claims, wherein the impedance parameters of the transmission line comprise one or more of:

   ABCD parameters of the transmission line; and
   a length of the transmission line.

13. Apparatus of a power network, the apparatus comprising one or more processors configured to perform the method according to any one of claims 1 to 12.

14. A computer program product comprising instructions that, when executed by one or more processors of a management system of a power network, cause the one or more processors to perform the method according to any one of claims 1 to 12.

15. A non-transitory computer-readable storage medium comprising the computer program product according to claim 14.

**P**  $I_P^1$  $I_{Fl}^1$  **F**  $I_{Fk}^1$  **M**  **S**  **N**  $I_C^1$  $I_Q^1$  **Q**

$I_F^1$

MØ

$V_P^1$  $V_F^1$  $V_Q^1$

$d$  $1$

$L$

$L_{total}$

Fig. 1

| S110 | obtain transmission line impedance parameters |
|---|---|

| S120 | obtain voltage and current at a first bus and second bus |
|---|---|

| S130 | obtain current through the series compensator |
|---|---|

| S140 | determine fault location |
|---|---|

Fig. 2

Fig. 3A

Fig. 3B

| S210 | obtain transmission line impedance parameters |
| --- | --- |

↓

| S220 | obtain voltage and current at a first bus and second bus |
| --- | --- |

↓

| S230 | obtain current through the series compensator |
| --- | --- |

↓

| S240 | determine fault section |
| --- | --- |

Fig. 4

S310 | obtain transmission line impedance parameters

S320 | obtain voltage and current at a first bus and second bus

S330 | obtain current through the series compensator

S340 | determine fault section

S350 | determine fault location in the determined fault section

Fig. 5

## EUROPEAN SEARCH REPORT

**Application Number**

EP 24 20 3899

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/178741 A1 (SAHA MURARI [SE]) 21 July 2011 (2011-07-21) * paragraph [0066] - paragraph [0133]; claims 1,9,17,19; figure 1 * ----- | 1-15 | INV. G01R31/08 |
| A | US 2015/301101 A1 (ABIDO MOHAMED ALI YOUSEF [SA] ET AL) 22 October 2015 (2015-10-22) * paragraph [0007]; claim 1 * ----- | 1-15 | |
| A | FECTEAU C: "Accurate fault location algorithm for series compensated lines using two-terminal unsynchronized measurements and hydro-quebec's field experience", ANNUAL WESTERN PROTECTIVE RELAY CONFERENCE,, vol. 33, 1 January 2006 (2006-01-01), pages 1-16, XP007906022, * Section 4.2 * ----- | 1-15 | |
| A | WO 2019/229638 A1 (ABB SCHWEIZ AG [CH]) 5 December 2019 (2019-12-05) * paragraph [0051] * ----- | 1-15 | **TECHNICAL FIELDS SEARCHED (IPC)** G01R |

The present search report has been drawn up for all claims

| Place of search | Date of completion of the search | Examiner |
|---|---|---|
| Munich | 14 March 2025 | Meliani, Chafik |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 722 743 A1**

## ANNEX TO THE EUROPEAN SEARCH REPORT
## ON EUROPEAN PATENT APPLICATION NO.

EP 24 20 3899

This annex lists the patent family members relating to the patent documents cited in the above-mentioned European search report.
The members are as contained in the European Patent Office EDP file on
The European Patent Office is in no way liable for these particulars which are merely given for the purpose of information.

14-03-2025

| Patent document cited in search report | | Publication date | Patent family member(s) | | Publication date |
|---|---|---|---|---|---|
| US 2011178741 | A1 | 21-07-2011 | CN | 102099698 A | 15-06-2011 |
| | | | EP | 2313791 A1 | 27-04-2011 |
| | | | RU | 2011106032 A | 27-08-2012 |
| | | | US | 2011178741 A1 | 21-07-2011 |
| | | | WO | 2010006652 A1 | 21-01-2010 |
| US 2015301101 | A1 | 22-10-2015 | NONE | | |
| WO 2019229638 | A1 | 05-12-2019 | NONE | | |

EPO FORM P0459

For more details about this annex : see Official Journal of the European Patent Office, No. 12/82

20

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **G. K. RAO** ; **P. JENA** ; **S. SARANGI**. Adaptive Fault Location Algorithm for Series Compensated Line Using Relay data. *2019 8th International Conference on Power Systems (ICPS)*, 2019, 1-5
- **M. M. SAHA** ; **J. IZYKOWSKI** ; **E. ROSOLOWSKI** ; **B. KASZTENNY**. A new accurate fault locating algorithm for series compensated lines. *IEEE Transactions on Power Delivery*, July 1999, vol. 14 (3), 789-797
- **SILVIO GIUSEPPE DI SANTO** ; **ALVARO DA ROCHA ALBERTINI** ; **RODRIGO ROZENBLIT TIFERES**. Optimization-Based Fault Location Algorithm for Series-Compensated Power Transmission Lines. *IEEE Access*, 2022, vol. 10, 46864-46877

- **N. KANG** ; **J. CHEN** ; **Y. LIAO**. A Fault-Location Algorithm for Series-Compensated Double-Circuit Transmission Lines Using the Distributed Parameter Line Model. *IEEE Transactions on Power Delivery*, February 2015, vol. 30 (1), 360-367
- **J. IZYKOWSKI** ; **E. ROSOLOWSKI** ; **P. BALCEREK** ; **M. FULCZYK** ; **M. M. SAHA**. Fault Location on Double-Circuit Series-Compensated Lines Using Two-End Unsynchronized Measurements. *IEEE Transactions on Power Delivery*, October 2011, vol. 26 (4), 2072-2080